# EUROPEAN PATENT SPECIFICATION

(11) **EP 4 095 907 B1**
(45) Date of publication and mention of the grant of the patent: **11.12.2024**
(21) Application number: 20938070.8
(22) Date of filing: 19.06.2020
(51) Int. Cl.: H01L 25/075, H01L 33/48, H01L 33/50, H01L 33/56, H01L 33/62, F21K 9/232, F21K 9/90, F21Y 115/10

(54) **FULL-SPECTRUM LED LIGHT SOURCE AND MANUFACTURING METHOD THEREFOR**
VOLLSPEKTRUM-LED-LICHTQUELLE UND HERSTELLUNGSVERFAHREN DAFÜR
SOURCE LUMINEUSE À DEL À SPECTRE CONTINU ET PROCÉDÉ ASSOCIÉ DE FABRICATION

(30) Priority: 25.05.2020 CN 202010450284
(43) Date of publication of application: 30.11.2022
(73) Proprietor: Zhongshan Mulinsen Electronics Co., Ltd., Guangdong 528415 (CN)
(72) Inventor: PI, Baoqing, Zhongshan, Guangdong 528415 (CN); LIU, Jiwei, Zhongshan, Guangdong 528415 (CN); SHI, Hongli, Zhongshan, Guangdong 528415 (CN)
(74) Representative: Plavsa, Olga
(86) International application number: PCT/CN2020/097193
(87) International publication number: WO 2021/237839

(56) References cited:
- CN-A- 103 840 071
- CN-A- 105 762 144
- CN-A- 110 137 164
- CN-U- 208 835 060
- US-A1- 2015 267 879

## Description

### TECHNICAL FIELD

The present disclosure relates to the technical field of a light-emitting diode (LED), and more specifically, to a full-spectrum LED light source and a manufacturing method thereof.

### BACKGROUND

With the continuous development of the LED industry, manufacturers no longer only consider a luminous efficiency or a service life, but also consider people's feelings for light and impacts of the light on people, hoping to produce artificial light closer to natural light. Full-spectrum LED light sources and healthy lighting have become hot spots in the industry in recent years.

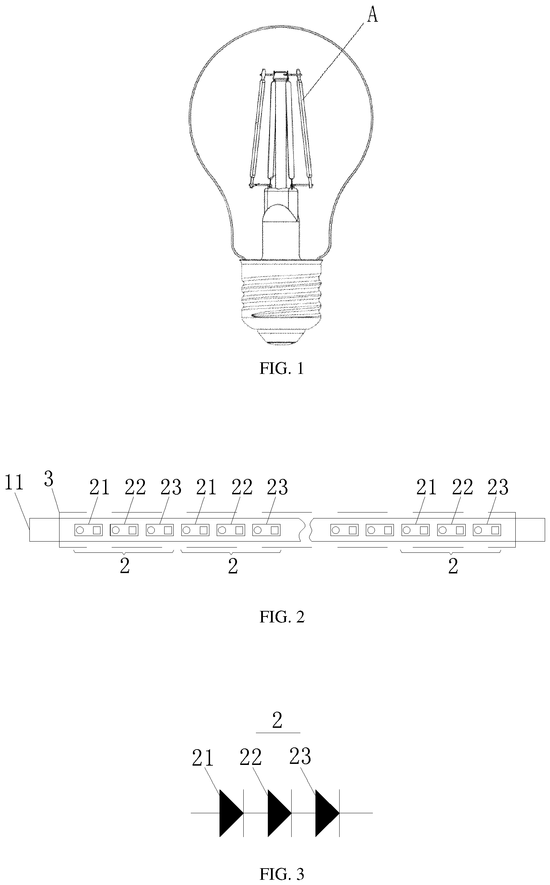

The full-spectrum LED light source is a light source that a spectrum thereof is similar to a solar spectrum and takes an LED as a light-emitting body. For example, LED filament A which is a light-emitting device of a bulb in FIG. 1 is a full-spectrum LED light source. A full-spectrum LED light source mainly includes a bracket, a chipset, and an encapsulation adhesive, and the chipset includes an LED capable of emitting blue light (hereinafter referred to as "blue LED chip"). A color rendering index (CRI) indicates an ability of a light source reproducing a visual experience of an object that is in sunlight. A higher color rendering property means that the closer a CRI value is to 100, the better a color reproduction capability for the object is, and it is easier for human eyes to distinguish a color of the object. An existing full-spectrum LED light source has a higher CRI (>95) than an ordinary LED light source. Except that values of the special CRIs R9 (saturated red) and R12 (saturated blue) are not ideal, other CRI values are all above 90.

In the prior art, there are already some improvement solutions for the problem that the values of the special CRIs R9 (saturated red) and R12 (saturated blue) are not ideal:
(1) Phosphor powder with a specific wavelength is added to an encapsulation adhesive covering on an outside of the blue LED chip. Light emitted by the phosphor powder with the specific wavelength excited by the blue LED chip supplements a missing spectrum, and has a spectrum with better continuity and closer to the solar spectrum. However, in a method that the LED light source uses the phosphor powder excited by the blue LED chip, excitation efficiency of phosphor powder with different wavelengths varies greatly. Specifically, red phosphor powder has high excitation efficiency, and blue-green phosphor powder has low excitation efficiency and dosages thereof are large, resulting in a poor luminous efficiency of the LED and a high cost. Although the value of the special CRI R9 (saturated red) of this full-spectrum LED light source has been improved to some extent, the value of the special CRI R12 (saturated blue) has not been significantly improved.
(2) In some improvement solutions, an LED capable of emitting purple light (hereinafter referred to as "purple LED chip") is used together with the blue LED chip. Although the values of the CRIs R9 and R12 can be increased and the luminous efficiency is reduced less, the purple LED chip has a more complex production process and a higher price than the blue LED chip, making a product cost high.
(3) CN110137164A discloses a method for realizing solar-spectrum-like white light with low blue light harm and a white-light LED. White light is form by exciting yellow phosphors, green phosphors and red phosphors with blue-light chips of three main wavelength ranges. The white light obtained is highly similar to the solar spectrum, close to natural light, low in blue light harm, beneficial to vision health. In the structural process, the yellow phosphors, the green phosphors, the red phosphors and an encapsulation adhesive are mixed, and then uniformly coat the surface of the blue-light chip by a centrifugal process, so that the phosphors can be uniformly excited.

### SUMMARY

A problem to be resolved by the present disclosure is to provide a full-spectrum LED light source and a manufacturing method thereof, which have a good luminous efficiency and a low cost, and can increase values of special CRIs R9 and R12 in R1 to R15 to more than 90.

To resolve the foregoing technical problem, a first aspect of the present invention provides a full-spectrum LED light source. The full-spectrum LED light source includes a bracket, a chipset, and an encapsulation adhesive, where the encapsulation adhesive is mixed with phosphor powder, and the chipset includes a first blue LED chip with a peak wavelength of 435 nm to 450 nm, a second blue LED chip with a peak wavelength of 450 nm to 460 nm, and a third blue LED chip with a peak wavelength of 460 nm to 475 nm that are connected in series or in parallel.

In the full-spectrum LED light source of the invention, the phosphor powder includes yellow phosphor powder with a peak emission wavelength of 540 nm to 550 nm under excitation by blue light, green phosphor powder with a peak emission wavelength of 490 nm to 530 nm under the excitation by the blue light, and red phosphor powder with a peak emission wavelength of 620 nm to 660 nm under the excitation by the blue light.

In the full-spectrum LED light source of the invention, and in accordance with the invention, a percent by weight of the yellow phosphor powder is 5% to 25%, a percent by weight of the green phosphor powder is 5% to 35%, a percent by weight of the red phosphor powder is 10% to 35%, and a percent by weight of the encapsulation adhesive is 40% to 80%.

As a preferred solution of the full-spectrum LED light source, the full-spectrum LED light source is a filament, the bracket is provided with a plurality of chipsets connected in series or in parallel, each of the chipsets includes the first blue LED chip, the second blue LED chip, and the third blue LED chip that are connected in series or in parallel in a specified arrangement order.

As a preferred solution of the full-spectrum LED light source, the specified arrangement order is the first blue LED chip, the second blue LED chip, and the third blue LED chip;
the specified arrangement order is the first blue LED chip, the third blue LED chip, and the second blue LED chip;
the specified arrangement order is the second blue LED chip, the first blue LED chip, and the third blue LED chip;
the specified arrangement order is the second blue LED chip, the third blue LED chip, and the first blue LED chip;
the specified arrangement order is the third blue LED chip, the first blue LED chip, and the second blue LED chip; or
the specified arrangement order is the third blue LED chip, the second blue LED chip, and the first blue LED chip.

A second aspect of the present invention provides a manufacturing method of a full-spectrum LED light source, including steps of:
providing a base plate, where the base plate is provided with at least one bracket for fixing a chip, the bracket is in a shape of a long strip and is printed with a series-parallel circuit electrically connected to the chip, both sides of each bracket are provided with at least one through groove parallel to the bracket, and the through groove is a groove body penetrating upper and lower surfaces of the base plate;
disposing a plurality of chipsets on the bracket, where the chipsets are connected in series or in parallel, each of the chipsets includes a first blue LED chip with a peak wavelength of 435 nm to 450 nm, a second blue LED chip with a peak wavelength of 450 nm to 460 nm, and a third blue LED chip with a peak wavelength of 460 nm to 475 nm that are connected in series or in parallel, and chipsets on a same bracket form a chipset column along a length direction of the bracket;
covering an encapsulation adhesive on upper and lower surfaces of a region on the bracket where a chip is disposed, where the encapsulation adhesive is filled in the through groove, and the encapsulation adhesive is mixed with phosphor powder; and
performing cutting along the through groove after the encapsulation adhesive is cured, to obtain a full-spectrum LED light source surrounded by the encapsulation adhesive.

In the manufacturing method of a full-spectrum LED light source according to the invention, the phosphor powder includes yellow phosphor powder with a peak emission wavelength of 540 nm to 550 nm under the excitation by the blue light, green phosphor powder with a peak emission wavelength of 490 nm to 530 nm under the excitation by the blue light, and red phosphor powder with a peak emission wavelength of 620 nm to 660 nm under the excitation by the blue light.

In the manufacturing method of a full-spectrum LED light source according to the invention, a percent by weight of the yellow phosphor powder is 5% to 25%, a percent by weight of the green phosphor powder is 5% to 35%, a percent by weight of the red phosphor powder is 10% to 35%, and a percent by weight of the encapsulation adhesive is 40% to 80%.

As a preferred solution of the manufacturing method of a full-spectrum LED light source, in a same chipset column, each of the chipsets includes the first blue LED chip, the second blue LED chip, and the third blue LED chip that are connected in series or in parallel in a specified arrangement order.

As a preferred solution of the manufacturing method of a full-spectrum LED light source, the specified arrangement order is the first blue LED chip, the second blue LED chip, and the third blue LED chip;
the specified arrangement order is the first blue LED chip, the third blue LED chip, and the second blue LED chip;
the specified arrangement order is the second blue LED chip, the first blue LED chip, and the third blue LED chip;
the specified arrangement order is the second blue LED chip, the third blue LED chip, and the first blue LED chip;
the specified arrangement order is the third blue LED chip, the first blue LED chip, and the second blue LED chip; or
the specified arrangement order is the third blue LED chip, the second blue LED chip, and the first blue LED chip.

Compared with the prior art, the full-spectrum LED light source and the manufacturing method thereof according to the present disclosure have the following beneficial effects:

The present disclosure adopts the blue LED chips of the three wave bands of 435 nm to 450 nm, 450 nm to 460 nm, and 460 nm to 475nm in a mix-and-match manner, supplements a missing spectrum while exciting the phosphor powder, increases values of special CRIs R9 (saturated red) and R12 (saturated blue) to above 90. The present disclosure has a good luminous efficiency and a low cost, and makes a spectrum closer to a solar spectrum, which can better reproduce a true color of a real object and makes a color of light comfortable and free from hurting eyes. Moreover, the present disclosure has a simple production process and high production efficiency, which is conducive to market promotion.

### BRIEF DESCRIPTION OF THE DRAWINGS

In order to explain the technical solutions of the embodiments of the present disclosure more clearly, accompanying drawings of the embodiments will be briefly introduced below.
FIG. 1 is a schematic structural diagram of an LED bulb, and an LED filament A which is a light-emitting device thereof is a full-spectrum LED light source;
FIG. 2 is a schematic structural diagram of a full-spectrum LED light source exemplified by a filament according to the present disclosure;
FIG. 3 is a schematic structural diagram of three blue LED chips in a chipset when the three blue LED chips are connected in series;
FIG. 4 is a schematic structural diagram of three blue LED chips in a chipset when the three blue LED chips are connected in parallel;
FIG. 5 is a schematic structural diagram of three blue LED chips in each chipset and of a plurality of chipsets, when the three blue LED chips in each chipset are connected in series and the plurality of chipsets are connected in series;
FIG. 6 is a schematic structural diagram of three blue LED chips in each chipset and of a plurality of chipsets, when the three blue LED chips in each chipset are connected in parallel and the plurality of chipsets are connected in parallel;
FIG. 7 is a schematic structural diagram of three blue LED chips in each chipset and of a plurality of chipsets, when the three blue LED chips in each chipset are connected in series and the plurality of chipsets are connected in parallel;
FIG. 8 is a schematic structural diagram of three blue LED chips in each chipset and of a plurality of chipsets, when the three blue LED chips in each chipset are connected in parallel and the plurality of chipsets are connected in series;
FIG. 9 is a structural schematic diagram of a base plate with a plurality of brackets;
FIG. 10 is a sectional view of the structure shown in FIG. 9 cutted along a line B-B;
FIG. 11 is a schematic structural diagram of the base plate after the plurality of brackets are covered with encapsulation adhesives;
FIG. 12 is a sectional view of the structure shown in FIG. 11 cutted along a line C-C;
FIG. 13 is a spectrogram of exciting an encapsulation adhesive by a single conventional blue LED chip;
FIG 14 is a spectrogram of exciting an encapsulation adhesive by a conventional blue LED chip and a purple LED chip; and
FIG. 15 is a spectrogram of a full-spectrum LED light source according to the present disclosure.

### DETAILED DESCRIPTION

The technical solutions in the embodiments of the present disclosure are clearly and completely described below with reference to the accompanying drawings in the embodiments of the present disclosure. Apparently, the described embodiments are merely a part rather than all of the embodiments of the present disclosure. All other embodiments obtained by a person of ordinary skill in the art based on the embodiments of the present disclosure without creative efforts shall fall within the protection scope of the present disclosure.

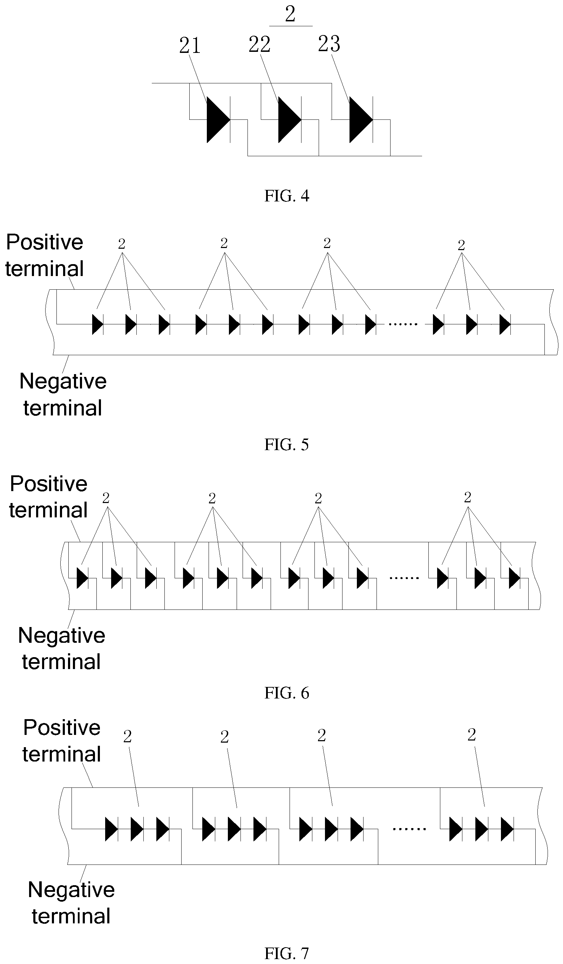

As shown in FIG. 2, according to a preferred embodiment of the present disclosure, a full-spectrum LED light source may be an LED filament or an LED bead, and in accordance with the invention includes a bracket 11, a chipset 2, and an encapsulation adhesive 3. The encapsulation adhesive 3 is mixed with phosphor powder, and the chipset 2 includes a first blue LED chip 21 with a peak wavelength of 435 nm to 450 nm, a second blue LED chip 22 with a peak wavelength of 450 nm to 460 nm, and a third blue LED chip 23 with a peak wavelength of 460 nm to 475 nm that are connected in series (as shown in FIG. 3) or in parallel (as shown in FIG. 4).

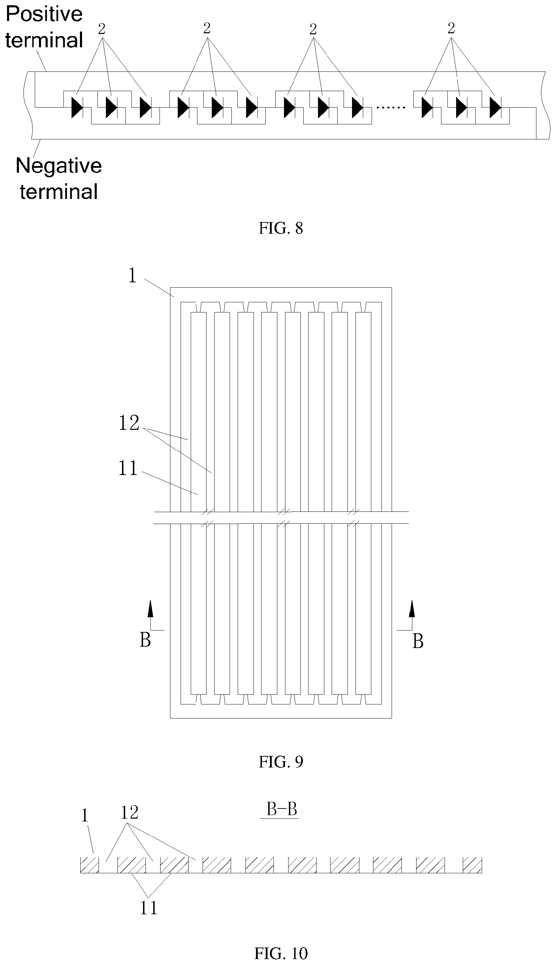

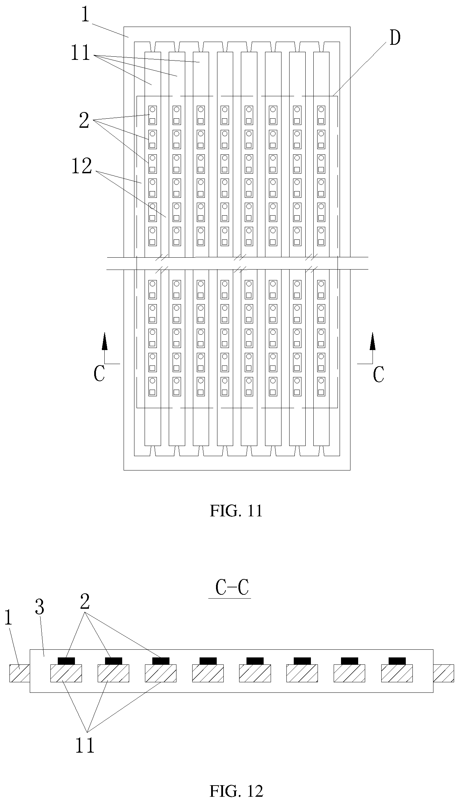

Based on the above full-spectrum LED light source, as shown in FIG. 9 to FIG. 12, by taking an LED filament as an example, a manufacturing method of the full-spectrum LED light source according to the invention includes steps of:
providing a base plate 1, where the base plate 1 is provided with at least one bracket 11 for fixing a chip, the bracket 11 is in a shape of a long strip, both sides of each bracket 11 are provided with at least one through groove 12 parallel to the bracket 11, the through groove 12 is a groove body penetrating upper and lower surfaces of the base plate 1, and the bracket 11 is optionally printed with a circuit electrically connected to the chip;
disposing a plurality of chipsets 2 on the bracket 11, where the chipsets 2 are connected in series or in parallel, each of the chipsets 2 includes the first blue LED chip 21 with a peak wavelength of 435 nm to 450 nm, the second blue LED chip 22 with a peak wavelength of 450 nm to 460 nm, and the third blue LED chip 23 with a peak wavelength of 460 nm to 475 nm that are connected in series or in parallel, and a plurality of chipsets 2 on a same bracket form a chipset column along a length direction of the bracket 11;
covering the encapsulation adhesive 3 on upper and lower surfaces of a region (a dashed region D in FIG. 11 ) on the bracket 11 where a chip is disposed, where the encapsulation adhesive 3 is filled in the through groove 12; and
performing cutting along the through groove 12 after the encapsulation adhesive 3 is cured, to obtain a full-spectrum LED light source surrounded by the encapsulation adhesive.

For example, the circuit on the bracket 11 includes at least the following four implementations:
(1) Series circuit: As shown in FIG. 5, the three blue LED chips in each chipset 2 are connected in series and the chipsets 2 are connected in series.
(2) Parallel circuit: As shown in FIG. 6, the three blue LED chips in each chipset 2 are connected in parallel and the chipsets 2 are connected in parallel.
(3) Series-parallel circuit: As shown in FIG. 7, the three blue LED chips in each chipset 2 are connected in series and the chipsets 2 are connected in parallel.
(4) Parallel-series circuit: As shown in FIG. 8, the three blue LED chips in each chipset 2 are connected in parallel and the chipsets 2 are connected in series.

For example, the bracket 11 is a transparent bracket, which helps the filament to emit light at 360 degrees.

In accordance with the invention, in order to make a spectrum of the LED light source closer to a solar spectrum, the phosphor powder includes yellow phosphor powder with a peak emission wavelength of 540 nm to 550 nm under excitation by blue light, green phosphor powder with a peak emission wavelength of 490 nm to 530 nm under the excitation by the blue light, and red phosphor powder with a peak emission wavelength of 620 nm to 660 nm under the excitation by the blue light Further in accordance with the invention, a percent by weight of the yellow phosphor powder is 5% to 25%, a percent by weight of the green phosphor powder is 5% to 35%, a percent by weight of the red phosphor powder is 10% to 35%, and a percent by weight of the encapsulation adhesive is 40% to 80%. In this embodiment, the encapsulation adhesive may include an epoxy resin adhesive and an epoxy resin curing agent. A weight ratio between the epoxy resin adhesive and the epoxy resin curing agent can be set with reference to the prior art, and details are not described herein.

For example, as shown in FIG. 1, in a same chipset column, each of the chipsets 2 includes the first blue LED chip 21, the second blue LED chip 22, and the third blue LED chip 23 that are connected in series or in parallel in a specified arrangement order.

For example, the specified arrangement order specifically includes the following implementations:
(1) the specified arrangement order is the first blue LED chip 21, the second blue LED chip 22, and the third blue LED chip 23;
(2) the specified arrangement order is the first blue LED chip 21, the third blue LED chip 23, and the second blue LED chip 22;
(3) the specified arrangement order is the second blue LED chip 22, the first blue LED chip 21, and the third blue LED chip 23;
(4) the specified arrangement order is the second blue LED chip 22, the third blue LED chip 23, and the first blue LED chip 21;
(5) the specified arrangement order is the third blue LED chip 23, the first blue LED chip 21, and the second blue LED chip 22; and
(6) the arrangement order is the third blue LED chip 23, the second blue LED chip 22, and the first blue LED chip 21.

Next, for characteristics of the above full-spectrum LED light source, a spectrum test is conducted for comparison:

Under a same test condition (including composition parameters of the phosphor powder), the spectrum test is separately conducted for light produced by the encapsulation adhesive 3 being excited by a single blue LED chip, being excited by a blue LED chip and a purple LED chip, or being excited by the full-spectrum LED light source in this embodiment, to perform comparison. A peak wavelength of one of the three blue LED chips of different bands of the full-spectrum LED light source in this embodiment is 450 nm to 460 nm, which is the same as that of the blue LED chip in the other two tests.

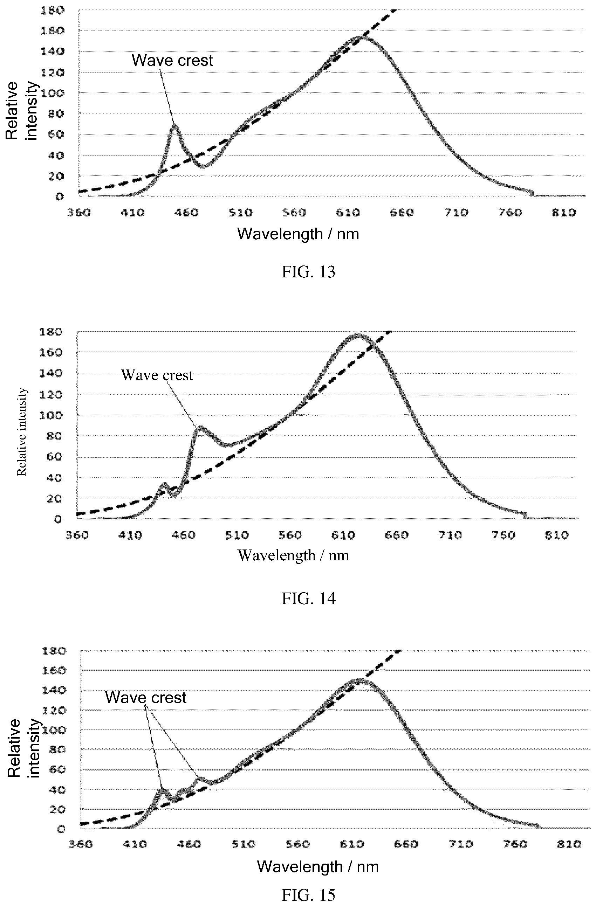

After the spectrum test, FIG. 13 is a spectrogram obtained when the single blue LED chip is tested, FIG. 14 is a spectrogram obtained when the blue LED chip and the purple LED chip are tested, and FIG. 15 is a spectrogram obtained when the full-spectrum LED light source in this embodiment is tested. Relative intensity in FIG. 13 to FIG. 15 is a value of another wavelength relative to 100 when an intensity value corresponding to the wavelength of 550 nm is 100. The three spectrograms obviously show that a wave crest of the full-spectrum LED light source in the blue band is lower, and relative intensity of the spectrum is closer to the solar spectrum. Moreover, in the spectrum of the full-spectrum LED light source, the three blue LED chips with different peak wavelengths are used, such that the phosphor powder can emit light in more bands under the excitation by blue light with high, medium, and low peak wavelengths, to supplement some missing spectra. A curve trend (indicated by a solid line in FIG. 13 to FIG. 15) of the spectrum of the full-spectrum LED light source is closer to a curve trend (indicated by a dotted line in FIG. 13 to FIG. 15) of the solar spectrum.

In addition, test data of CRI values of R1 to R15 of the full-spectrum LED light source in the embodiments of the present disclosure is shown in Table 1. It can be seen from Table 1 that the CRI values of R1 to R15 can reach above 95.

**Table 1**

| R1 | R2 | R3 | R4 | R5 | R6 | R7 | R8 | R9 | R10 | R11 | R12 | R13 | R14 | R15 |
|---|---|---|---|---|---|---|---|---|---|---|---|---|---|---|
| 99.5 | 99.9 | 98.7 | 98.8 | 99.2 | 99.1 | 99.0 | 99.7 | 98.9 | 98.8 | 99.3 | 96.7 | 99.5 | 98.9 | 99.3 |

The full-spectrum LED light source and the manufacturing method thereof provided in the embodiments of the present disclosure adopt the blue LED chips of the three wave bands of 435 nm to 450 nm, 450 nm to 460 nm, and 460 nm to 475nm in a mix-and-match manner, supplements a missing spectrum while exciting the phosphor powder, increases values of special CRIs R9 (saturated red) and R12 (saturated blue) to more than 90. The full-spectrum LED light source and the manufacturing method thereof have a good luminous efficiency and a low cost, and make the spectrum closer to the solar spectrum, which can better reproduce a true color of a real object and makes a color of light comfortable and free from hurting eyes. Moreover, the full-spectrum LED light source and the manufacturing method thereof have a simple production process and high production efficiency, which is conducive to market promotion.

The embodiments disclosed above are only preferred embodiments of the present disclosure, and are not intended to limit the claimed scope of the present invention. The scope of the invention is only defined by the appended claims.

## Claims

1. A full-spectrum light-emitting diode (LED) light source, comprising a bracket (11), a chipset (2), and an encapsulation adhesive (3), wherein the encapsulation adhesive (3) is mixed with phosphor powder, and the chipset (2) comprises a first blue LED chip (21) with a peak wavelength of 435 nm to 450 nm, a second blue LED chip (22) with a peak wavelength of 450 nm to 460 nm, and a third blue LED chip (23) with a peak wavelength of 460 nm to 475 nm that are connected in series or in parallel;
wherein the phosphor powder comprises yellow phosphor powder with a peak emission wavelength of 540 nm to 550 nm under excitation by blue light, green phosphor powder with a peak emission wavelength of 490 nm to 530 nm under the excitation by the blue light, and red phosphor powder with a peak emission wavelength of 620 nm to 660 nm under the excitation by the blue light;
**characterized in that** a percent by weight of the yellow phosphor powder is 5% to 25%, a percent by weight of the green phosphor powder is 5% to 35%, a percent by weight of the red phosphor powder is 10% to 35%, and a percent by weight of the encapsulation adhesive (3) is 40% to 80%.

2. The full-spectrum LED light source according to claim 1, wherein the full-spectrum LED light source is a filament, the bracket (11) is provided with a plurality of chipsets (2) connected in series or in parallel, each of the chipsets (2) comprises the first blue LED chip (21), the second blue LED chip (22), and the third blue LED chip (23) that are connected in series or in parallel in a specified arrangement order.

3. The full-spectrum LED light source according to claim 2, wherein the specified arrangement order is the first blue LED chip (21), the second blue LED chip (22), and the third blue LED chip (23);
the specified arrangement order is the first blue LED chip (21), the third blue LED chip (23), and the second blue LED chip (22);
the specified arrangement order is the second blue LED chip (22), the first blue LED chip (21), and the third blue LED chip (23);
the specified arrangement order is the second blue LED chip (22), the third blue LED chip (23), and the first blue LED chip (21);
the specified arrangement order is the third blue LED chip (23), the first blue LED chip (21), and the second blue LED chip (22); or
the specified arrangement order is the third blue LED chip (23), the second blue LED chip (22), and the first blue LED chip (21).

4. A manufacturing method of a full-spectrum LED light source, comprising steps of:
providing a base plate (1), wherein the base plate (1) is provided with at least one bracket (11) for fixing a chip, the bracket (11) is in a shape of a long strip and is printed with a series-parallel circuit electrically connected to the chip, both sides of each bracket (11) are provided with at least one through groove (12) parallel to the bracket (11), and the through groove (12) is a groove body penetrating upper and lower surfaces of the base plate (1);
disposing a plurality of chipsets (2) on the bracket (11), wherein the chipsets (2) are connected in series or in parallel, each of the chipsets (2) comprises a first blue LED chip (21) with a peak wavelength of 435 nm to 450 nm, a second blue LED chip (22) with a peak wavelength of 450 nm to 460 nm, and a third blue LED chip (23) with a peak wavelength of 460 nm to 475 nm that are connected in series or in parallel, and chipsets (2) on a same bracket (11) form a chipset column along a length direction of the bracket (11);
covering an encapsulation adhesive (3) on upper and lower surfaces of a region on the bracket (11) where a chip is disposed, wherein the encapsulation adhesive (3) is filled in the through groove (12), and the encapsulation adhesive (3) is mixed with phosphor powder; and
performing cutting along the through groove (12) after the encapsulation adhesive (3) is cured, to obtain a full-spectrum LED light source surrounded by the encapsulation adhesive (3),
wherein the phosphor powder comprises yellow phosphor powder with a peak emission wavelength of 540 nm to 550 nm under excitation by blue light, green phosphor powder with a peak emission wavelength of 490 nm to 530 nm under the excitation by the blue light, and red phosphor powder with a peak emission wavelength of 620 nm to 660 nm under the excitation by the blue light,
**characterized in that** a percent by weight of the yellow phosphor powder is 5% to 25%, a percent by weight of the green phosphor powder is 5% to 35%, a percent by weight of the red phosphor powder is 10% to 35%, and a percent by weight of the encapsulation adhesive (3) is 40% to 80%.

5. The manufacturing method of a full-spectrum LED light source according to claim 4, wherein in a same chipset column, each of the chipsets (2) comprises the first blue LED chip (21), the second blue LED chip (22), and the third blue LED chip (23) that are connected in series or in parallel in a specified arrangement order.

6. The manufacturing method of a full-spectrum LED light source according to claim 5, wherein the specified arrangement order is the first blue LED chip (21), the second blue LED chip (22), and the third blue LED chip (23);
the specified arrangement order is the first blue LED chip (21), the third blue LED chip (23), and the second blue LED chip (22);
the specified arrangement order is the second blue LED chip (22), the first blue LED chip (21), and the third blue LED chip (23);
the specified arrangement order is the second blue LED chip (22), the third blue LED chip (23), and the first blue LED chip (21);
the specified arrangement order is the third blue LED chip (23), the first blue LED chip (21), and the second blue LED chip (22); or
the specified arrangement order is the third blue LED chip (23), the second blue LED chip (22), and the first blue LED chip (21).

## Patentansprüche

1. Eine Vollspektrum-Licht emittierende Diode (LED)-Lichtquelle, umfassend einen Halter (11), einen Chipsatz (2) und einen Verkapselungskleber (3), wobei der Verkapselungskleber (3) mit Leuchtstoffpulver gemischt ist und der Chipsatz (2) einen ersten blauen LED-Chip (21) mit einer Spitzenwellenlänge von 435 nm bis 450 nm, einen zweiten blauen LED-Chip (22) mit einer Spitzenwellenlänge von 450 nm bis 460 nm und einen dritten blauen LED-Chip (23) mit einer Spitzenwellenlänge von 460 nm bis 475 nm umfasst, die in Reihe oder parallel geschaltet sind;
wobei das Leuchtstoffpulver gelbes Leuchtstoffpulver mit einer Emissionsspitzenwellenlänge von 540 nm bis 550 nm unter Anregung durch blaues Licht, grünes Leuchtstoffpulver mit einer Emissionsspitzenwellenlänge von 490 nm bis 530 nm unter Anregung durch blaues Licht und rotes Leuchtstoffpulver mit einer Emissionsspitzenwellenlänge von 620 nm bis 660 nm unter Anregung durch blaues Licht umfasst;
**gekennzeichnet durch** ein Gewichtsprozent des gelben Leuchtstoffpulvers von 5 % bis 25 %, ein Gewichtsprozent des grünen Leuchtstoffpulvers von 5 % bis 35 %, ein Gewichtsprozent des roten Leuchtstoffpulvers von 10 % bis 35 % und ein Gewichtsprozent des Verkapselungsklebers (3) von 40 % bis 80 %.

2. Die Vollspektrum-LED-Lichtquelle gemäß Anspruch 1, wobei die Vollspektrum-LED-Lichtquelle ein Filament ist, der Halter (11) mit einer Vielzahl von Chipsätzen (2) versehen ist, die in Reihe oder parallel geschaltet sind, wobei jeder Chipsatz (2) den ersten blauen LED-Chip (21), den zweiten blauen LED-Chip (22) und den dritten blauen LED-Chip (23) umfasst, die in Reihe oder parallel in einer bestimmten Anordnungsreihenfolge geschaltet sind.

3. Die Vollspektrum-LED-Lichtquelle gemäß Anspruch 2, wobei die bestimmte Anordnungsreihenfolge der erste blaue LED-Chip (21), der zweite blaue LED-Chip (22) und der dritte blaue LED-Chip (23) ist;
wobei die bestimmte Anordnungsreihenfolge der erste blaue LED-Chip (21), der dritte blaue LED-Chip (23) und der zweite blaue LED-Chip (22) ist;
wobei die bestimmte Anordnungsreihenfolge der zweite blaue LED-Chip (22), der erste blaue LED-Chip (21) und der dritte blaue LED-Chip (23) ist;
wobei die bestimmte Anordnungsreihenfolge der zweite blaue LED-Chip (22), der dritte blaue LED-Chip (23) und der erste blaue LED-Chip (21) ist;
wobei die bestimmte Anordnungsreihenfolge der dritte blaue LED-Chip (23), der erste blaue LED-Chip (21) und der zweite blaue LED-Chip (22) ist; oder
wobei die bestimmte Anordnungsreihenfolge der dritte blaue LED-Chip (23), der zweite blaue LED-Chip (22) und der erste blaue LED-Chip (21) ist.

4. Ein Herstellungsverfahren einer Vollspektrum-LED-Lichtquelle, umfassend die Schritte:
Bereitstellen einer Grundplatte (1), wobei die Grundplatte (1) mit mindestens einem Halter (11) zum Fixieren eines Chips versehen ist, der Halter (11) in Form eines langen Streifens vorliegt und mit einer Reihenschaltungs-Schaltung bedruckt ist, die elektrisch mit dem Chip verbunden ist. Beide Seiten jedes Halters (11) sind mit mindestens einer Durchrille (12) versehen, die parallel zum Halter (11) verläuft, und die Durchrille (12) ist ein Rillenkörper, der die oberen und unteren Oberflächen der Grundplatte (1) durchdringt;
Anordnen einer Vielzahl von Chipsätzen (2) auf dem Halter (11), wobei die Chipsätze (2) in Reihe oder parallel geschaltet sind, wobei jeder der Chipsätze (2) einen ersten blauen LED-Chip (21) mit einer Spitzenwellenlänge von 435 nm bis 450 nm, einen zweiten blauen LED-Chip (22) mit einer Spitzenwellenlänge von 450 nm bis 460 nm und einen dritten blauen LED-Chip (23) mit einer Spitzenwellenlänge von 460 nm bis 475 nm umfasst, die in Reihe oder parallel geschaltet sind, und Chipsätze (2) auf einem gleichen Halter (11) bilden eine Chipsatz-Spalte entlang einer Längsrichtung des Halters (11);
Abdecken der oberen und unteren Oberflächen eines Bereichs des Halters (11), wo ein Chip angeordnet ist, mit einem Verkapselungskleber (3), wobei der Verkapselungskleber (3) in die Durchrille (12) gefüllt ist und der Verkapselungskleber (3) mit Leuchtstoffpulver gemischt ist; und
Durchführen eines Schneidens entlang der Durchrille (12) nach dem Aushärten des Verkapselungsklebers (3), um eine von Verkapselungskleber (3) umgebene Vollspektrum-LED-Lichtquelle zu erhalten;
wobei das Leuchtstoffpulver gelbes Leuchtstoffpulver mit einer Emissionsspitzenwellenlänge von 540 nm bis 550 nm unter Anregung durch blaues Licht, grünes Leuchtstoffpulver mit einer Emissionsspitzenwellenlänge von 490 nm bis 530 nm unter Anregung durch blaues Licht und rotes Leuchtstoffpulver mit einer Emissionsspitzenwellenlänge von 620 nm bis 660 nm unter Anregung durch blaues Licht umfasst;
**gekennzeichnet durch** ein Gewichtsprozent des gelben Leuchtstoffpulvers von 5 % bis 25 %, ein Gewichtsprozent des grünen Leuchtstoffpulvers von 5 % bis 35 %, ein Gewichtsprozent des roten Leuchtstoffpulvers von 10 % bis 35 % und ein Gewichtsprozent des Verkapselungsklebers (3) von 40 % bis 80 %.

5. Das Herstellungsverfahren einer Vollspektrum-LED-Lichtquelle gemäß Anspruch 4, wobei in einer gleichen Chipsatz-Spalte, wobei jeder Chipsatz (2) den ersten blauen LED-Chip (21), den zweiten blauen LED-Chip (22) und den dritten blauen LED-Chip (23) umfasst, die in Reihe oder parallel in einer bestimmten Anordnungsreihenfolge geschaltet sind.

6. Das Herstellungsverfahren einer Vollspektrum-LED-Lichtquelle gemäß Anspruch 5, wobei die bestimmte Anordnungsreihenfolge der erste blaue LED-Chip (21), der zweite blaue LED-Chip (22) und der dritte blaue LED-Chip (23) ist;
wobei die bestimmte Anordnungsreihenfolge der erste blaue LED-Chip (21), der dritte blaue LED-Chip (23) und der zweite blaue LED-Chip (22) ist;
wobei die bestimmte Anordnungsreihenfolge der zweite blaue LED-Chip (22), der erste blaue LED-Chip (21) und der dritte blaue LED-Chip (23) ist;
wobei die bestimmte Anordnungsreihenfolge der zweite blaue LED-Chip (22), der dritte blaue LED-Chip (23) und der erste blaue LED-Chip (21) ist;
wobei die bestimmte Anordnungsreihenfolge der dritte blaue LED-Chip (23), der erste blaue LED-Chip (21) und der zweite blaue LED-Chip (22) ist; oder
wobei die bestimmte Anordnungsreihenfolge der dritte blaue LED-Chip (23), der zweite blaue LED-Chip (22) und der erste blaue LED-Chip (21) ist.

## Revendications

1. Une source de lumière d'une diode électroluminescente (DEL) à spectre complet, comprenant un support (11), un jeu de puces (2) et un adhésif d'encapsulation (3), où en ce que l'adhésif d'encapsulation (3) est mélangé à de la poudre de phosphore, et les jeux de puces (2) comprend une première puce DEL bleue (21) avec une longueur d'onde maximale de 435nm à 450nm, une deuxième puce DEL bleue (22) avec une longueur d'onde maximale de 450nm à 460nm, et une troisième puce DEL bleue (23) avec une longueur d'onde maximale de 460nm à 475nm, connectés en série ou en parallèle ;
où en ce que la poudre de phosphore comprenant une poudre de phosphore jaune ayant une longueur d'onde d'émission maximale de 540nm à 550nm sous excitation par la lumière bleue, une poudre de phosphore vert ayant une longueur d'onde d'émission maximale de 490nm à 530nm sous excitation par la lumière bleue, et un phosphore rouge poudre avec une longueur d'onde d'émission maximale de 620nm à 660nm sous excitation par la lumière bleue ;
**caractérisé en ce qu'**un pourcentage en poids de poudre de phosphore jaune est de 5% à 25%, un pourcentage en poids de poudre de phosphore vert est de 5% à 35%, un pourcentage en poids de poudre de phosphore rouge est de 10% à 35% , et un pourcentage en poids de l'adhésif d'encapsulation (3) est de 40% à 80%.

2. La source de lumière d'une DEL à spectre complet selon la revendication 1, où en ce que la source de lumière DEL à spectre complet est un filament, le support (11) est pourvu de beaucoup de jeux de puces (2) connectés en série ou en parallèle, chacun des jeux de puces (2) comprend la première puce DEL bleue (21), la deuxième puce DEL bleue (22) et la troisième puce DEL bleue (23) qui sont connectées en série ou en parallèle dans un ordre d'agencement spécifié.

3. La source de lumière d'une DEL à spectre complet selon la revendication 2, où en ce que l'ordre d'agencement spécifié est la première puce DEL bleue (21), la deuxième puce DEL bleue (22) et la troisième puce DEL bleue (23) ;
l'ordre d'agencement spécifié est la première puce DEL bleue (21), la troisième puce DEL bleue (23) et la deuxième puce DEL bleue (22) ;
l'ordre d'agencement spécifié est la deuxième puce DEL bleue (22), la première puce DEL bleue (21) et la troisième puce DEL bleue (23) ;
l'ordre d'agencement spécifié est la deuxième puce DEL bleue (22), la troisième puce DEL bleue (23) et la première puce DEL bleue (21) ;
l'ordre d'agencement spécifié est la troisième puce DEL bleue (23), la première puce DEL bleue (21) et la deuxième puce DEL bleue (22) ; ou
l'ordre d'agencement spécifié est la troisième puce DEL bleue (23), la deuxième puce DEL bleue (22) et la première puce DEL bleue (21).

4. Un procédé de fabrication d'une source lumineuse d'une DEL à spectre complet, comprenant les étapes suivantes :
fournissant une plaque de base (1), la plaque de base (1) étant dotée d'au moins un support (11) pour fixer une puce, le support (11) a la forme d'une longue bande et est imprimé avec une série- circuit parallèle connecté électriquement à la puce, les deux côtés de chaque support (11) sont pourvus d'au moins une rainure traversante (12) parallèle au support (11), et la rainure traversante (12) est un corps de rainure pénétrant dans le haut et le bas des surfaces de la plaque de base (1) ;
disposant beaucoup des jeux de puces (2) sur le support (11), les jeux de puces (2) étant connectés en série ou en parallèle, chacun des jeux de puces (2) comprend une première puce DEL bleue (21) avec une longueur d'onde maximale de 435nm à 450nm, une deuxième puce DEL bleue (22) avec une longueur d'onde maximale de 450nm à 460nm, et une troisième puce DEL bleue (23) avec une longueur d'onde maximale de 460nm à 475nm qui sont connectées en série ou en parallèle, et des jeux de puces (2) sur un même support (11) forment une colonne de chipsets le long d'une direction longitudinale du support (11) ;
recouvrant un adhésif d'encapsulation (3) sur les surfaces supérieure et inférieure d'une région du support (11) où une puce est disposée, l'adhésif d'encapsulation (3) étant rempli dans la rainure traversante (12), et l'adhésif d'encapsulation (3) est mélangé à de la poudre de phosphore ; et
effectuant une découpe le long de la rainure traversante (12) après que l'adhésif d'encapsulation (3) ait durci, pour obtenir une source de lumière DEL à spectre complet entourée par l'adhésif d'encapsulation (3),
où en ce que la poudre de phosphore comprenant une poudre de phosphore jaune ayant une longueur d'onde d'émission maximale de 540nm à 550nm sous excitation par la lumière bleue, une poudre de phosphore vert ayant une longueur d'onde d'émission maximale de 490nm à 530nm sous excitation par la lumière bleue, et un phosphore rouge poudre avec une longueur d'onde d'émission maximale de 620 nm à 660 nm sous excitation par la lumière bleue,
**caractérisé en ce qu'**un pourcentage en poids de poudre de phosphore jaune est de 5% à 25%, un pourcentage en poids de poudre de phosphore vert est de 5% à 35%, un pourcentage en poids de poudre de phosphore rouge est de 10% à 35% , et un pourcentage en poids de l'adhésif d'encapsulation (3) est de 40% à 80%.

5. Le procédé de fabrication d'une source de lumière DEL à spectre complet selon la revendication 4, dans lequel dans une même colonne de chipsets, chacun de jeu des jeux de puces (2) comprend la première puce DEL bleue (21), la seconde puce DEL bleue (22), et la troisième puce DEL bleue (23) qui est connectée en série ou en parallèle dans un ordre d'agencement spécifié.

6. Le procédé de fabrication d'une source de lumière DEL à spectre complet selon la revendication 5, dans lequel l'ordre d'agencement spécifié est la première puce DEL bleue (21), la deuxième puce DEL bleue (22) et la troisième puce DEL bleue (23) ;
l'ordre d'agencement spécifié est la première puce DEL bleue (21), la troisième puce de DEL bleue (23) et la deuxième puce DEL bleue (22) ;
l'ordre d'agencement spécifié est la deuxième puce DEL bleue (22), la première puce DEL bleue (21) et la troisième puce DEL bleue (23) ;
l'ordre d'agencement spécifié est la deuxième puce DEL bleue (22), la troisième puce de DEL bleue (23) et la première puce DEL bleue (21) ;
l'ordre d'agencement spécifié est la troisième puce DEL bleue (23), la première puce DEL bleue (21) et la deuxième puce DEL bleue (22) ; ou
l'ordre d'agencement spécifié est la troisième puce DEL bleue (23), la deuxième puce DEL bleue (22) et la première puce DEL bleue (21).
